# EUROPEAN PATENT APPLICATION

(11) **EP 4 675 392 A1**
(43) Date of publication of application: **07.01.2026**
(21) Application number: 24210448.7
(22) Date of filing: 04.11.2024
(51) Int. Cl.: G06F 1/16, G06F 1/28, G06F 1/30

(54) **DISPLAY DEVICE AND OPERATING METHOD THEREOF**

(30) Priority: 05.07.2024 KR 20240088974
(71) Applicant: LG Electronics Inc., Yeongdeungpo-gu Seoul 07336 (KR)
(72) Inventor: JEOUNG, Taekeun, 06772 Seoul (KR)
(74) Representative: Vossius & Partner Patentanwälte Rechtsanwälte mbB

(57) **Abstract**

A display device according to an embodiment of the present disclosure may comprise a stand and a head supported by the stand, including a display and a battery, wherein the head is electrically connected through a pogo pin provided in a connector of the stand, wherein the head further comprises a main board configured to obtain an operating state of the head and an input voltage input to the head through the pogo pin, and determine whether an error has occurred in the pogo pin based on the operating state of the head and the input voltage.

## Description

### BACKGROUND OF THE INVENTION

### 1.Field of the Invention

The present disclosure relates to a display device, and more specifically, to a stand-type display device.

### 2. Discussion of the Related Art

Stand-type display device is a product with unique design and convenient function, providing a user with a new type of viewing experience.

The stand-type display device is equipped with wheel on the stand, so it may be easily moved and used anywhere in the house. This allows the display device to be conveniently used in various spaces such as the kitchen, living room, and bedroom.

Additionally, the stand-type display device may rotate the screen 90 degrees, allowing it to be used in both portrait and landscape modes. This makes it useful for viewing photo, working with document, and using social media.

In addition, the stand-type display device may adjust the height and angle of the screen, allowing convenient viewing according to the user's gaze.

The stand-type display device is equipped with a pogo pin for electrical connection between the head and the stand to supply external power, and is equipped with a battery to supply power to the head when the external power is not connected.

A burn out of the pogo pin, a poor contact, or a corrosion phenomenon due to a poor coating is an inevitable reliability item.

When a defect of the pogo pin occurs, the battery cannot be fully charged due to a drop in voltage provided by an adapter. In other words, the voltage supplied to the battery must be above a certain voltage, but due to the defect in the pogo pin, the voltage above the certain voltage cannot be supplied. As a result, the battery does not reach a full charge state, and an internal temperature of the battery rises due to continuous charging.

In conclusion, there is a risk of fire occurring due to overheating and damage to the battery as the battery continues to be charged despite an error of the pogo pin.

In addition, conventionally, a temperature sensor was used to detect pogo pin error by sensing the temperature around the contact point of the pogo pin to reduce the risk of ignition, but when used in an area with a high ambient temperature, there is a risk of malfunction due to an increase in the temperature of the temperature sensor.

### SUMMARY OF THE INVENTION

The purpose of the present disclosure may be to detect damage to the pogo pin for electrical connection between the head and the stand.

The purpose of the present disclosure may be to predict a connection state according to an operating state of the head and a charging state of the battery when connecting power using the pogo pin.

The purpose of the present disclosure may be to accurately measure whether an error has occurred in the pogo pin by performing a two-step verification to determine whether an error has occurred in the pogo pin according to each operation state of the head.

A display device according to an embodiment of the present disclosure may comprise a stand and a head supported by the stand, including a display and a battery, wherein the head is electrically connected through a pogo pin provided in a connector of the stand,

wherein the head further comprises a main board configured to obtain an operating state of the head and an input voltage input to the head through the pogo pin, and determine whether an error has occurred in the pogo pin based on the operating state of the head and the input voltage.

A method of operating a display device, wherein the display device comprises a stand and a head supported by the stand, including a display and a battery; the head is electrically coupled to the stand through a pogo pin provided in a connector of the stand, may comprise obtaining an operating state of the head and an input voltage input to the head through the pogo pin and determining whether an error has occurred in the pogo pin based on the operating state of the head and the input voltage.

According to an embodiment of the present disclosure, damage to the pogo pin for electrical connection between the head and the stand is detected, thereby preventing the possibility of a fire occurring in advance.

According to an embodiment of the present disclosure, when connecting power using the pogo pin, the connection state of the pogo pin is predicted according to the voltage and a power consumption state, and accordingly, maintaing the power-off state of the display device and a notification is notified to the user to prevent fire and overheating due to battery charging.

According to an embodiment of the present disclosure, whether an error occurs in the pogo pin is performed through a two-step verification according to each operation state of the head, so that whether an error occurs in the pogo pin may be accurately detected.

### BRIEF DESCRIPTION OF THE DRAWINGS

FIGS. 1A and 1B are diagrams illustrating the structure of a display device according to an embodiment of the present disclosure.
FIG. 2 is a block diagram showing the configuration of a display device according to an embodiment of the present disclosure.
FIGS. 3A and 3B are diagrams illustrating the structure of a display device according to an embodiment of the present disclosure from a power supply perspective.
FIG. 4 is a diagram illustrating the configuration of a charging board according to an embodiment of the present disclosure.
FIG. 5 is a diagram illustrating a circuit diagram of a detection circuit according to an embodiment of the present disclosure.
FIG. 6 is a diagram illustrating the operating principle of an LDO circuit according to an embodiment of the present disclosure.
FIGS. 7 to 10 are diagrams illustrating a process of determining whether an error has occurred in the pogo pin based on the operating state of the head and the charging state of the battery according to an embodiment of the present disclosure.
FIG. 11 is a diagram illustrating an error verification method of the pogo pin according to each operation state of the head according to the present disclosure.
FIG. 12 is a diagram illustrating a control circuit according to an embodiment of the present disclosure.
FIG. 13 is a diagram illustrating the reason for increasing the power consumed by the head when the head is in the third operation state according to an embodiment of the present disclosure.
FIG. 14 is a flowchart for illustrating a method of operating a display device according to another embodiment of the present disclosure.

### DETAILED DESCRIPTION OF THE PREFERRED EMBODIMENTS

Hereinafter, embodiments related to the present invention will be described in more detail with reference to the drawing. The suffixes "module" and "part" for component used in the following description are given or used interchangeably only for the ease of preparing the specification, and do not have distinct meanings or roles in themselves.

The directional indications Up (U), Down (D), Left (Le), Right (Ri), Front (F), and Rear (R) shown in the drawings are provided for the convenience of explanation only and do not limit the technical ideas disclosed in this specification.

The display device according to an embodiment of the present invention is, for example, an intelligent display device that adds a computer support function to the broadcast reception function, and is faithful to the broadcast reception function while adding an Internet function, etc., such as a handwriting input device and a touch screen. Alternatively, it may be equipped with a more convenient interface such as a spatial remote control. In addition, by supporting wired or wireless Internet functions, it is possible to connect to the Internet and a computer and perform functions such as email, web browsing, banking, or gaming. A standardized general-purpose OS may be used for these various functions.

Accordingly, in the display device described in the present invention, for example, various applications may be freely added or deleted on a general-purpose OS kernel, so various user-friendly functions may be performed. More specifically, the display device may be, for example, a network TV, HBBTV, smart TV, LED TV, OLED TV, etc., and in some cases, may also be applied to a smartphone.

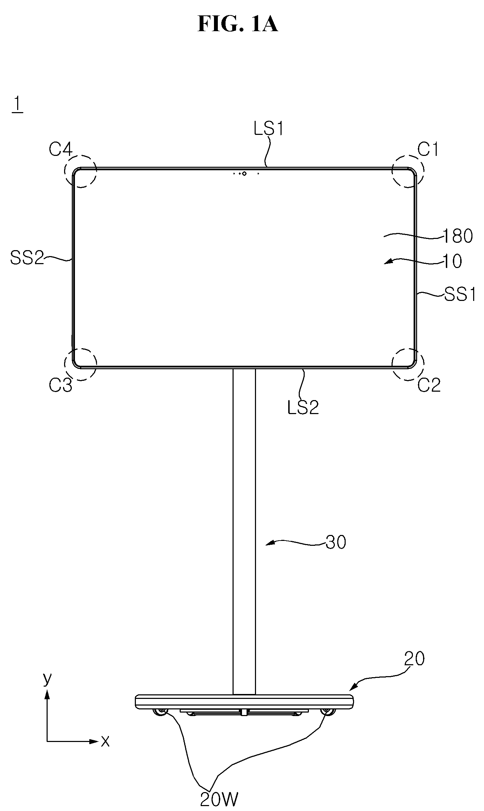

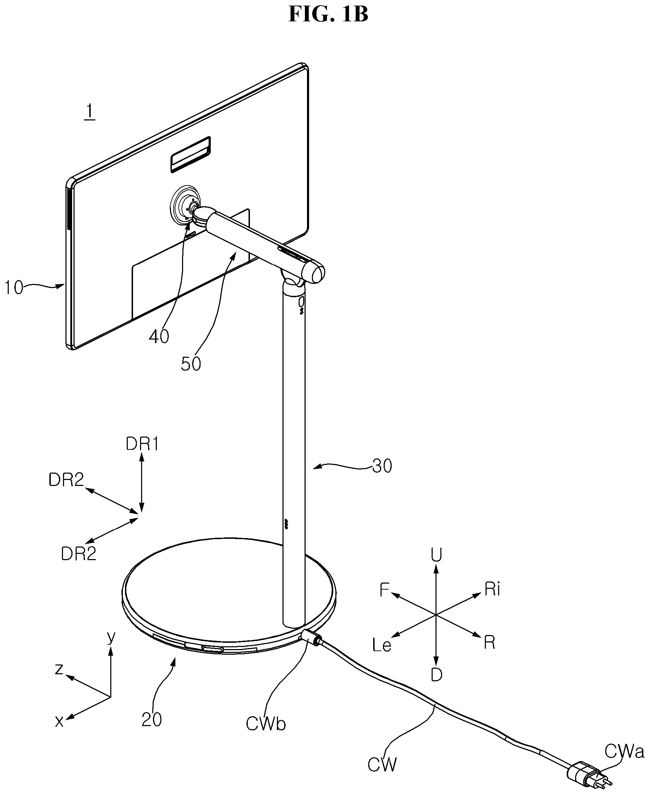

FIGS. 1A and 1B are diagrams illustrating the structure of a display device according to an embodiment of the present disclosure.

FIGS.1A and 1B, the display device 1 may include a head 10. The head 10 may include a display panel that displays an image.

The head 10 may include a first long side (LS1), a second long side (LS2) opposing the first long side (LS1), a first short side (SS1) adjacent to the first long side (LS1), and the second long side (LS2) and a second short side (SS2) opposite to the first short side (SS1).

Meanwhile, for convenience of explanation, the length of the first and second long sides LS1 and LS2 is shown and described as being longer than the length of the first and second short sides SS1 and SS2. It may be possible that the length of the second long sides LS1 and LS2 is approximately the same as the length of the first and second short sides SS1 and SS2.

A direction parallel to the short sides (SS1, SS2) of the head 10 may be referred to as an up-down direction or a first direction DR1. The direction parallel to the long sides LS1 and LS2 of the head 10 may be referred to as a left and right direction or a second direction DR2. A direction perpendicular to the short sides (SS1, SS2) and long sides (LS1, LS2) of the head 10 may be referred to as a forward-backward direction or a third direction DR3.

The direction in which the head 10 displays an image may be referred to as a front (F, z), and the opposite direction may be referred to as a rear (R). The first short side (SS1) may be referred to as a left side (Le, x). The second short side (SS2) may be referred to as a right side (Ri). The first long side (LS1) may be referred to as a upper side (U, y). The second long side (LS2) may be referred to as a bottom side (D).

The first long side (LS1), the second long side (LS2), the first short side (SS1), and the second short side (SS2) may be referred to as edges of the head 10. The point where the first long side (LS1), the second long side (LS2), the first short side (SS1), and the second short side (SS2) meet each other may be called a corner. The point where the first short side (SS1) and the first long side (LS1) meet may be the first corner (C1). The point where the first short side (SS1) and the second long side (LS2) meet may be the second corner (C2). The point where the second short side (SS2) and the second long side (LS2) meet may be the third corner (C3). The point where the second short side (SS2) and the first long side (LS1) meet may be the fourth corner (C4).

The display device 1 may include stand 20, 30, 40, and 50 that support the head 10.

The stand 20, 30, 40, and 50 may include a base 20, a pole 30, a rotatable connector 40, and a support arm 50.

The stand 20, 30, 40, and 50 may be detachably coupled to the head 10.

The base 20 may be placed on the ground. The base 20 may be round or angular. A plurality of wheels 20W may be provided on a lower surface of the base 20.

A plug (CWa) connected to a power cable (CW) may be connected to an concentric plug that supplies an external power

A jack (CWb) of the power cable (CW) may be connected to the base 20.

A battery (not shown) may be built into the base 20, pole 30, support arm 50, and/or head 10, and may be charged by power supplied through the power cable (CW). The display device 1 may receive power from the battery and may be operated while disconnected from the power cable (CW).

The pole 30 may extend vertically from the base 20. A lower end of the pole 30 may be coupled to the pole 30 adjacent to a circumference of the base 20.

The support arm 50 may extend in a direction crossing the pole 30 and may be coupled to a top of the pole 30. The rotatable connector 40 may be located between the head 10 and the support arm 50 and may be coupled to the head 10 and the support arm 50.

The head 10 may be supported by stand 20, 30, 40, and 50 and may be spaced upward from the ground.

The rotatable connector 40 may rotate the head 10 up and down or left and right. When an external force is applied to the rotatable connector 40, the head 10 may be rotated in one or more of the up/down/left/right directions.

The rotatable connector 40 and the head 10 may have a detachable structure.

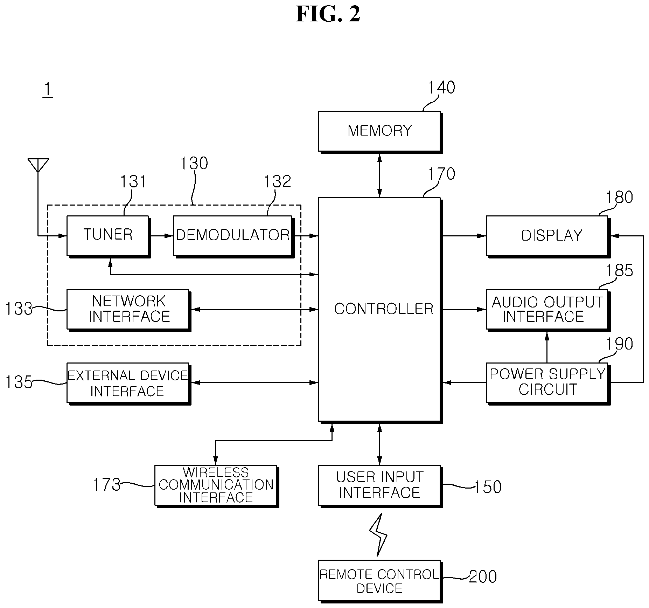

FIG. 2 is a block diagram showing a configuration of a display device according to an embodiment of the present disclosure.

Referring to FIG. 2, the display device 1 may include a broadcast receiver 130, an external device interface 135, a memory 140, a user input interface 150, a controller 170, a wireless communication interface 173, a display 180, a speaker 185, and a power supply circuit 190.

The broadcast receiver 130, the external device interface 135, the memory 140, the user input interface 150, the controller 170, the wireless communication interface 173, the display 180, the speaker 185, and the power supply circuit 190 may each be provided in the head 10. However, they are not limited to this arrangement, and some elements may also be provided in the stand 20, 30, 40, 50.

The broadcast receiver 130 may include a tuner 131, a demodulator 132, and a network interface 133.

The tuner 131 may select a specific broadcast channel according to a channel selection command. The tuner 131 may receive a broadcast signal for the selected specific broadcast channel.

The demodulator 132 may separate the received broadcast signal into an image signal, an audio signal, and a data signal related to a broadcast program, and restore the separated image signal, audio signal, and data signal to a format capable of being output.

The external device interface 135 may receive an application or a list of applications in an external device adjacent thereto, and transmit the same to the controller 170 or the memory 140.

The external device interface 135 may provide a connection path between the display device 1 and an external device. The external device interface 135 may receive one or more of images and audio output from an external device connected to the display device 1 in a wired or wireless manner, and transmit the same to the controller 170.

The external device interface 135 may include a plurality of external input terminals. The plurality of external input terminals may include an RGB terminal, one or more High Definition Multimedia Interface (HDMI) terminals, and a component terminal.

The image signal of the external device input through the external device interface unit 135 may be output through the display 180. The audio signal of the external device input through the external device interface 135 may be output through the speaker 185.

The external device connectable to the external device interface 135 may be any one of a set-top box, a Blu-ray player, a DVD player, a game machine, a sound bar, a smartphone, a PC, a USB memory, and a home theater, but this is only an example.

The external device interface 135 may be provided in one or more of the head 10 or the stand 20, 30, 40, 50.

The network interface 133 may provide an interface for connecting the display device 1 to a wired/wireless network including an Internet network.

The network interface 133 may transmit or receive data to or from other users or other electronic devices through a connected network or another network linked to the connected network.

In addition, a part of content data stored in the display device 1 may be transmitted to a selected user among a selected user or a selected electronic device among other users or other electronic devices registered in advance in the display device 1.

The network interface 133 may access a predetermined web page through the connected network or the other network linked to the connected network. That is, it is possible to access a predetermined web page through a network, and transmit or receive data to or from a corresponding server.

The network interface 133 may receive content or data provided by a content provider or a network operator. That is, the network interface 133 may receive content such as movies, advertisements, games, VOD, and broadcast signals and information related thereto provided from a content provider or a network provider through a network.

The network interface 133 may receive update information and update files of firmware provided by the network operator, and may transmit data to an Internet or content provider or a network operator.

The network interface 133 may select and receive a desired application from among applications that are open to the public through a network.

The memory 140 may store programs for signal processing and control of the controller 170, and may store images, audio, or data signals, which have been subjected to signal-processed.

The memory 140 may perform a function for temporarily storing images, audio, or data signals input from an external device interface 135 or the network interface 133, and store information on a predetermined image through a channel storage function.

The memory 140 may store an application or a list of applications input from the external device interface 135 or the network interface 133.

The display device 1 may play back a content file (a moving image file, a still image file, a music file, a document file, an application file, or the like) stored in the memory 140 and provide the same to the user.

The user input interface 150 may transmit a signal input by the user to the controller 170 or a signal from the controller 170 to the user. For example, the user input interface 150 may receive and process a control signal such as power on/off, channel selection, screen settings, and the like from the remote control device 200 in accordance with various communication methods, such as a Bluetooth communication method, a WB (Ultra Wideband) communication method, a ZigBee communication method, an RF (Radio Frequency) communication method, or an infrared (IR) communication method or may perform processing to transmit the control signal from the controller 170 to the remote control device 200.

In addition, the user input interface 150 may transmit a control signal input from a local key (not shown) such as a power key, a channel key, a volume key, and a setting value to the controller 170.

The image signal image-processed by the controller 170 may be input to the display 180 and displayed as an image corresponding to a corresponding image signal. Also, the image signal image-processed by the controller 170 may be input to an external output device through the external device interface 135.

The audio signal processed by the controller 170 may be output to the speaker 185. Also, the audio signal processed by the controller 170 may be input to the external output device through the external device interface 135.

In addition, the controller 170 may control the overall operation of the display device 1.

In addition, the controller 170 may control the display device 1 by a user command input through the user input interface 150 or an internal program and connect to a network to download an application a list of applications or applications desired by the user to the display device 1.

The controller 170 may allow the channel information or the like selected by the user to be output through the display 180 or the speaker 185 along with the processed image or audio signal.

In addition, the controller 170 may output an image signal or an audio signal through the display 180 or the speaker 185, according to a command for playing back an image of an external device through the user input interface 150, the image signal or the audio signal being input from an external device, for example, a camera or a camcorder, through the external device interface 135.

Meanwhile, the controller 170 may allow the display 180 to display an image, for example, allow a broadcast image which is input through the tuner 131 or an external input image which is input through the external device interface 135, an image which is input through the network interface unit or an image which is stored in the memory 140 to be displayed on the display 180. In this case, an image being displayed on the display 180 may be a still image or a moving image, and may be a 2D image or a 3D image.

In addition, the controller 170 may allow content stored in the display device 1, received broadcast content, or external input content input from the outside to be played back, and the content may have various forms such as a broadcast image, an external input image, an audio file, still images, accessed web screens, and document files.

The wireless communication interface 173 may communicate with an external device through wired or wireless communication. The wireless communication interface 173 may perform short range communication with an external device. To this end, the wireless communication interface 173 may support short range communication using at least one of Bluetooth^{™}, Radio Frequency Identification (RFID), Infrared Data Association (IrDA), Ultra Wideband (UWB), ZigBee, Near Field Communication (NFC), Wi-Fi (Wireless-Fidelity), Wi-Fi(Wireless-Fidelity), Wi-Fi Direct, and Wireless USB (Wireless Universal Serial Bus) technologies.

The wireless communication interface 173 may support wireless communication between the display device 1 and a wireless communication system, between the display device 1 and another display device 1, or between the display device 1 and a network in which the display device 1 (or an external server) is located through wireless area networks. The wireless area networks may be wireless personal area networks.

The wireless communication interface 173 may detect (or recognize) a wearable device capable of communication around the display device 1.

When the detected wearable device is an authenticated device to communicate with the display device 1 according to the present disclosure, the controller 170 may transmit at least a portion of data processed by the display device 1 to the wearable device through the wireless communication interface 173. Therefore, a user of the wearable device may use data processed by the display device 1 through the wearable device.

The display 180 may convert image signals, data signals, and OSD signals processed by the controller 170, or image signals or data signals received from the external device interface 135 into R, G, and B signals, and generate drive signals.

Meanwhile, since the display device 1 shown in FIG. 1 is only an embodiment of the present disclosure, some of the illustrated components may be integrated, added, or omitted depending on the specification of the display device 1 that is actually implemented.

That is, two or more components may be combined into one component, or one component may be divided into two or more components as necessary. In addition, a function performed in each block is for describing an embodiment of the present disclosure, and its specific operation or device does not limit the scope of the present disclosure.

According to another embodiment of the present disclosure, unlike the display device 1 shown in FIG. 1, the display device 1 may receive an image through the network interface 133 or the external device interface 135 without a tuner 131 and a demodulator 132 and play back the same.

For example, the display device 1 may be divided into an image processing device, such as a set-top box, for receiving broadcast signals or content according to various network services, and a content playback device that plays back content input from the image processing device.

In this case, an operation method of the display device according to an embodiment of the present disclosure will be described below may be implemented by not only the display device 1 as described with reference to FIG. 1 and but also one of an image processing device such as the separated set-top box and a content playback device including the display 180 the speaker 185.

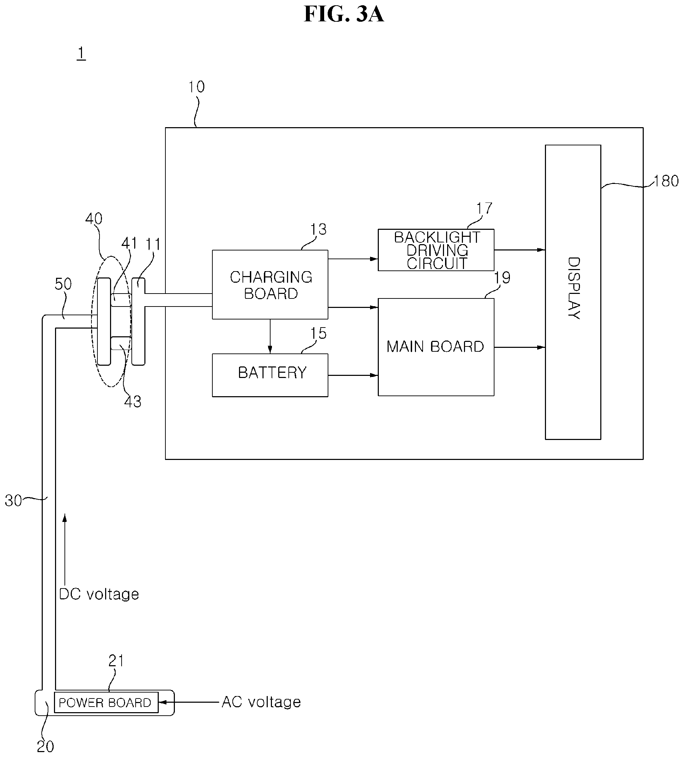

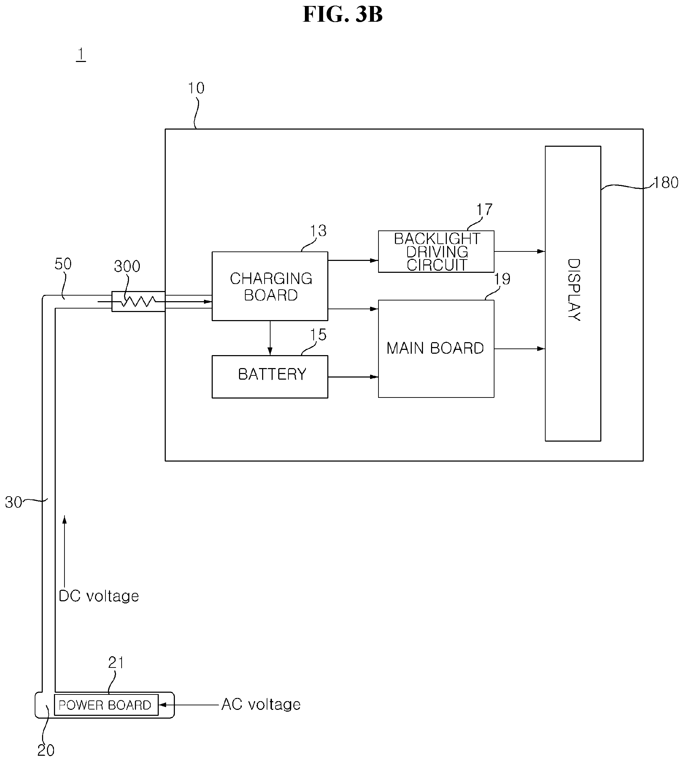

FIGS. 3A and 3B are diagrams illustrating the structure of a display device according to an embodiment of the present disclosure from a power supply perspective.

Referring to FIG. 3A, the display device 1 may include stand 20, 30, 40, and 50 and a head 10.

The stand 20, 30, 40, and 50 may include a base 20, a pole 30, a rotatable connector 40, and a support arm 50.

The stand 20, 30, 40, and 50 may be detachably coupled to the head 10.

The base 20 may include a power board 21. That is, the power board 21 may be built into the base 20. The power board 21 may receive an AC power from an external power source connected through the plug (CWa) and convert the received AC power into a DC power. The power board 21 may supply the DC power to the head 10 through one or more pogo pin 41, 43 included in the rotatable connector 40.

The power board 21 may include an adapter that may convert the AC power to the DC power.

The rotatable connector 40 may include one or more pogo pin 41, 43. One or more pogo pin 41, 43 may be pins that electrically connect the head 10 and the stand 20, 30, 40, and 50.

In FIG. 3A, the rotatable connector 40 is described as having two pogo pin 41, 43, but this is only an example.

One or more pogo pin 41, 43 may be connected to a head connector 11 that includes one or more contact terminals that contact the one or more pogo pin 41, 43. The head connector 11 may be a pogo pin socket into which pogo pin 41, 43 are inserted to form electrical contact.

The head 10 may include the head connector 11, a charging board 13, a battery 15, a backlight driving circuit 17, a main board 19, and a display 180.

The head connector 11 may include one or more pogo pin 41, 43 and one or more contact terminals for electrical contact. The head connector 11 may provide direct current power supplied from one or more pogo pin 41, 43 to the charging board 13 through one or more contact terminals. The head connector 11 may be an interface for electrical connection between one or more pogo pin 41, 43 and the charging board 13.

The charging board 13 may provide direct current power supplied from the power board 21 to the elements provided in the head 10.

The charging board 13 may provide direct current power supplied from the power board 21 to one or more of the battery 15, the backlight driving circuit 17, or the main board 19.

The battery 15 may supply direct current power to one or more of the backlight driving circuit 17 or the main board 19.

The battery 15 may be included in the charging board 13 or may be provided separately from the charging board 13.

The battery 15 may supply direct current power to the head 10 through a discharge when the power board 21 or the adapter provided on the power board 21 is separated from the head 10.

The backlight driving circuit 17 may be a circuit for driving a backlight of the display 180. The display 180 may include a liquid crystal display panel and the backlight that outputs light to the liquid crystal display panel. The backlight driving circuit 17 may control the light output of the backlight based on a dimming value.

The main board 19 may control an overall operation of the head 10. The main board 19 may include one or more processors. Each of one or more processors may consist of one chip.

The main board 19 may obtain the operating state of the head 10.

The main board 19 may obtain an input voltage of the charging board 13, which is input to the charging board 13 of the head 10 through the pogo pin 41, 43.

The main board 19 may determine whether an error has occurred in the pogo pin 41, 43 based on the obtained operating state of the head and the input voltage of the charging board 13.

If it is determined that the error has occurred in the pogo pin 41, 43 (S707), the main board 19 may control the charging of the battery 15 to be turned off.

The display 180 may display an image. When the display 180 includes an Organic Light Emitting Diode (OLED) display panel, the backlight driving circuit 17 may not be included in the head 10.

FIG. 3B is a diagram illustrating an example in which one or more pogo pin 41, 43 are expressed as a resistor 300 when one or more pogo pin 41, 43 are expressed as an equivalent circuit.

As more a damage occurs to the pogo pin 41, 43, a resistance value of the pogo pin 41, 43 may increase.

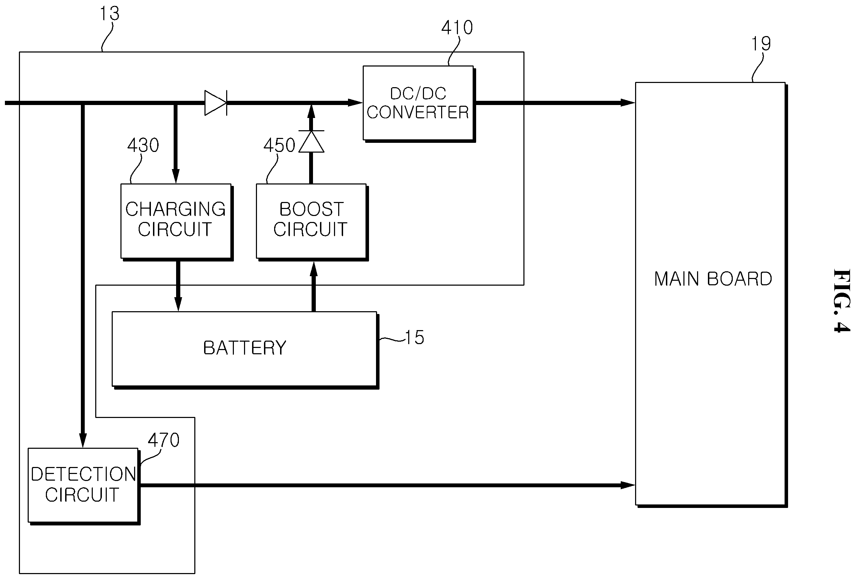

FIG. 4 is a diagram illustrating the configuration of a charging board according to an embodiment of the present disclosure.

The charging board 13 may include a DC/DC converter 410, a charging circuit 430, a boost circuit 450, and a detection circuit 470.

The DC/DC converter 410 may convert the direct current power delivered from the power board 21 into a constant voltage and supply the converted constant voltage to the main board 19.

For example, the DC/DC converter 410 may step down a direct current voltage of 20V to 13V and supply the stepped-down direct current voltage of 13V to the main board 19.

The charging circuit 430 may charge the battery 15 using direct current power delivered from the power board 21. The charging circuit 430 may control charging or discharging of the battery 15. The charging circuit 430 may include a battery management system integrated chip (BMS IC) for controlling charging or discharging of the battery 15.

The charging circuit 430 may charge the battery 15 according to a charging on signal received from the main board 19 and stop charging the battery 15 according to a charging off signal.

The boost circuit 450 may change the output voltage of the battery 15 to a preset voltage and provide the changed voltage to the DC/DC converter 410. The boost circuit 450 may increase the output voltage of the battery 15 to a preset voltage and output the increased voltage.

For example, the boost circuit 450 may convert the output voltage of the battery 15 into a direct current voltage of 17.5V and output the direct current voltage of 17.5V.

The detection circuit 470 may detect the fastening state of the pogo pin 41, 43 using the direct current power output from the pogo pin 41, 43. The detection circuit 470 may detect whether there is an error in the pogo pin 41, 43 using the direct current power output from the pogo pin 41, 43 and input to the charging board 13.

The detection circuit 470 may detect whether the pogo pin 41, 43 are fastened using the direct current power output from the pogo pin 41, 43, and may transmit a detection result to the main board 19.

The detection circuit 470 may include one or more Zener diodes and a Low DropOut (LDO) circuit.

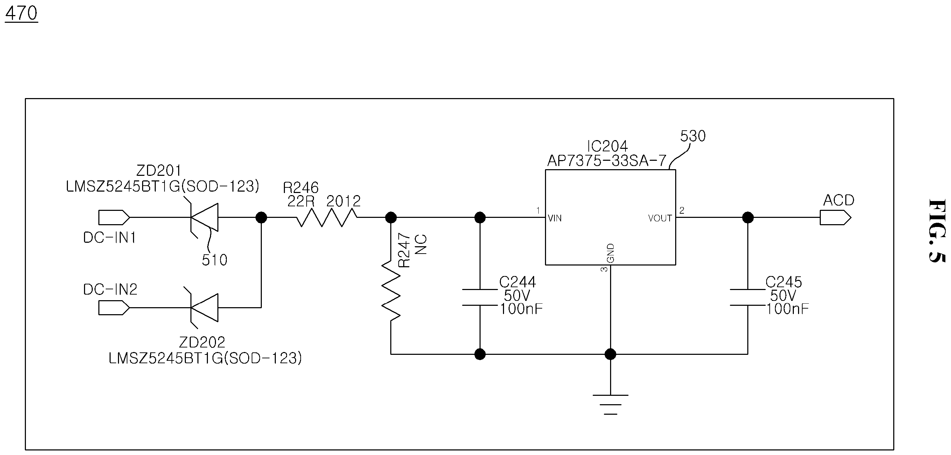

FIG. 5 is a diagram illustrating a circuit diagram of a detection circuit according to an embodiment of the present disclosure.

Referring to FIG. 5 , the detection circuit 470 may include a Zener diode 510 and an LDO circuit 530. The detection circuit 470 may further include a plurality of resistors (R246, R247) and a capacitor (C244) connected between the Zener diode 510 and the LDO circuit 530.

The input voltage input to the charging board 13 through the pogo pin 41, 43 may be applied to a cathode terminal of the Zener diode 510. One end of the resistor R246 may be connected to an anode terminal of the Zener diode 510.

The detection circuit 470 may further include a capacitor C245 connected between the LDO circuit 530 and the ACD pin (ACD).

The Zener diode 510 may be a diode designed to allow current to flow in the reverse direction at a specific voltage (or Zener voltage). The Zener voltage of the Zener diode 510 may be 15.5V.

When 20V output from the pogo pin 41, 43 is input to the cathode terminal of the Zener diode 510, 4.5V, which is 20V minus 15.5V, which is the Zener voltage, may be applied to the LDO circuit 530.

The LDO circuit 530 may be a circuit that outputs a preset voltage when the input voltage is more than a certain voltage. The LDO circuit 530 may output 3.3V when the input voltage is 3.5V or more, and may reduce the output voltage depending on the input voltage when the input voltage is less than 3.5V. When the input voltage is less than 3.5V, the LDO circuit 530 may linearly reduce the output voltage according to the input voltage.

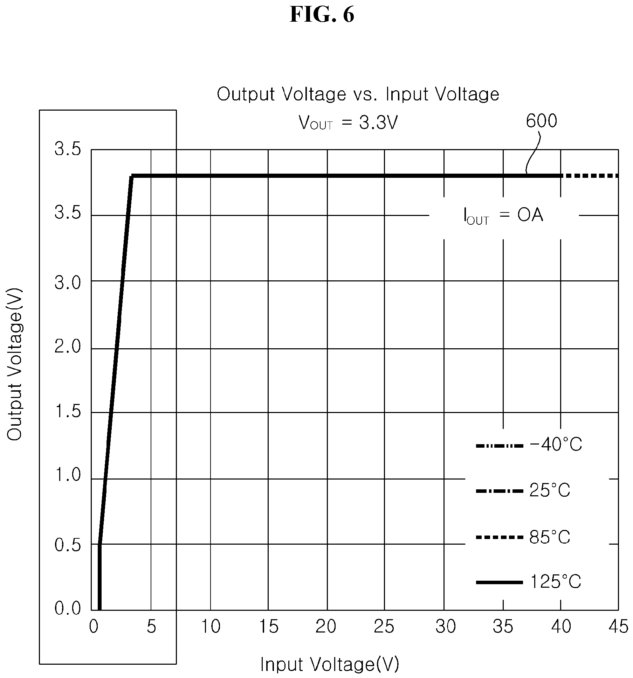

FIG. 6 is a diagram illustrating the operating principle of an LDO circuit according to an embodiment of the present disclosure.

Referring to FIG. 6, a graph 600 representing the relationship between the input voltage and output voltage of the LDO circuit 530 is shown.

A horizontal axis of the graph 600 may represent the input voltage of the LDO circuit 530, and A vertical axis of the graph 600 may represent the output voltage output from the LDO circuit 530.

The LDO circuit 530 may output a constant voltage of 3.3V when the input voltage is 3.5V or more. When the input voltage is less than 3.5V, the LDO circuit 530 may output an output voltage proportional to the input voltage.

When the input voltage of the LDO circuit 530 is 3.5V to 4.5V, the output voltage of the LDO circuit 530 is always 3.3V, but when the input voltage is less than 3.5V, the output voltage may also be reduced in proportion to the input voltage, as shown in the graph 600.

When a DC voltage of 20V is applied to the detection circuit 470, a DC voltage of 4.5V may be applied to the LDO circuit 530 by the Zener diode 510 with a Zener voltage of 15.5V. Since the input voltage of the LDO circuit 530 is 3.5V or more, it may output 3.3V.

When a DC voltage of 18V is applied to the detection circuit 470, a DC voltage of 2.5V may be applied to the LDO circuit 530 by the Zener diode 510 with a Zener voltage of 15.5V. Since the input voltage of the LDO circuit 530 is less than 3.5V, it may output 1.7V according to the graph 600.

The output voltage of the LDO circuit 530 may be the output voltage of the detection circuit 470.

The main board 19 may determine whether the pogo pin 41, 43 are poorly fastened based on the output voltage of the detection circuit 470.

The main board 19 may determine whether the pogo pin 41, 43 are poorly fastened based on the operating state of the head 10 and the output voltage of the detection circuit 470.

The operating state of the head 10 may be a combination of one or more of a screen on state of the display 180, a screen off state of the display 180, a charge on state of the battery 15, or a charge off state of the battery 15.

The screen off state may be a state in which no power is supplied to the display 180 or a standby state in which only a minimum amount of power is supplied to the display 180.

Hereinafter, a full charge state of the battery 15 may indicate a state in which the battery 15 is fully charged.

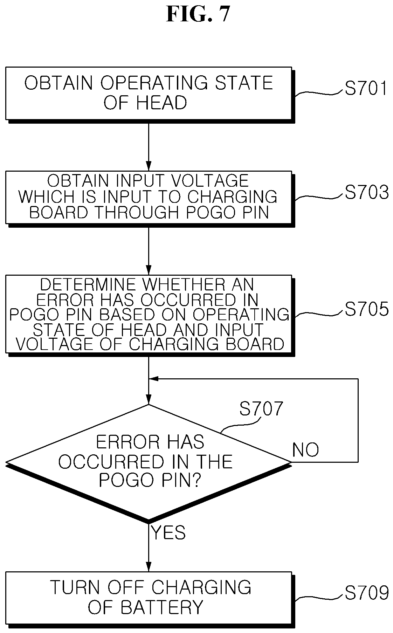

FIGS. 7 to 10 are diagrams illustrating a process of determining whether an error has occurred in the pogo pin based on the operating state of the head and the charging state of the battery according to an embodiment of the present disclosure.

FIG. 7 is a flowchart illustrating a method of operating a display device according to an embodiment of the present disclosure.

Referring to FIG. 7, the main board 19 of the display device 1 may obtain the operating state of the head 10 (S701).

In one embodiment, the operating state of the head 10 may be a state representing a combination between the screen state of the display 180 and the charging state of the battery 15.

The screen state of the display 180 may be either the screen off state in which the screen is turned off or the screen on state in which the screen is turned on.

The charging state of the battery 15 may be either the charge on state in which the battery 15 is being charged or the charge off state in which the battery 15 is not being charged. When the battery 15 is fully charged, the battery 15 may not be charged. Accordingly, the full charge state of the battery 15 may be treated the same as the charge off state.

Head 10 may be in any one of a plurality of operating states.

The first operating state of the head 10 may be the screen on state of the display 180 and the charge on state of the battery 15.

The second operating state of the head 10 may be the screen on state and the charge off state of the battery 15.

The third operating state of the head 10 may be the screen off state and the charge on state of the battery 15.

The fourth operating state of the head 10 may be the screen off state and the charge off state of the battery 15.

The main board 19 of the display device 1 may obtain the input voltage of the charging board 13, which is input to the charging board 13 of the head 10 through the pogo pin 41, 43 (S703).

The main board 19 may obtain the voltage at a point connected to the charging board 13 from the head connector 11 in electrical contact with the pogo pin 41, 43. The voltage at the point where the head connector 11 electrically contacts the pogo pin 41, 43 is connected to the charging board 13 may be the input voltage of the charging board 13.

The main board 19 of the display device 1 may determine whether an error has occurred in the pogo pin 41, 43 based on the obtained operating state of the head and the input voltage of the charging board 13 (S705).

The error in the pogo pins (41, 43) may be caused by one or more of a damage to the pogo pins (41, 43) themselves, a poor contact between the pogo pins (41, 43) and the head connector (11), a presence of foreign substance on the pogo pins (41, 43) or a foreign substance on the contact terminal of the head connector 11.

In one embodiment, the main board 19 may perform a primary verification based on the obtained operating state of the head 10 and the input voltage of the charging board 13, and determine whether there is an error in pogo pin 41, 43 based on a verification result of the primary verification.

In another embodiment, the main board 19 may perform a secondary verification after the primary verification based on the obtained operating state of the head 10 and the input voltage of the charging board 13, and determine whether there is an error in the pogo pin 41, 43 based on a verification result of the secondary verification.

The main board 19 may obtain the output voltage of the detection circuit 470 provided in the charging board 13 based on the input voltage of the charging board 13.

The main board 19 may determine whether there is an error in the pogo pin 41, 43 based on the operating state of the head 10 and the output voltage of the detection circuit 470.

If it is determined that an error has occurred in the pogo pin 41, 43 (S707), the main board 19 of the display device 1 may control the charging of the battery 15 to be turned off (S709).

If it is determined that an error has occurred in the pogo pin 41, 43, the main board 19 may transmit a charge off signal to the charging board 13 to stop charging the battery 15. The charging board 13 may stop charging the battery 15 according to the charging off signal.

Accordingly, the battery 15 is continuously charged, preventing the potential risks of overheating and fire from occurring in advance.

When it is determined that the error has occurred in the pogo pin 41, 43, the main board 19 may display a notification indicating an occurrence of the error in the pogo pin 41, 43 on the display 180. The notification may include a text and an image indicating that one or more problems, a poor fastening of the pogo pin 41, 43 or a damage of the pogo pin 41, 43, have occurred.

After a certain period of time, the main board 19 may turn off the screen of the display 180 (standby state) or for a system stability. Afterwards, the main board 19 may turn off charging of the battery 15.

In the screen off state of the display 180 and the charge off state of the battery 15, ae power consumption of the head 10 is less than 0.5W, so the possibility of ignition due to the pogo pin 41, 43 may be eliminated.

The main board 19 may display a guide for a damage check or a reconnection of the pogo pin 41, 43 using the power charged in the battery 15 on the display 180.

When it is determined that the error has occurred in the pogo pin 41, 43, the main board 19 may discharge the battery 15 to turn on the screen of the display 180 while turning off the charging of the battery 15. The main board 190 may display a notification indicating the occurrence of the error in the pogo pin 41, 43 on the turned-on screen.

The user may immediately check a status of the pogo pin 41, 43 and take an action through the notification displayed on the screen.

In another embodiment, when it is determined that the error has occurred in the pogo pin 41, 43, the main board 19 may turn off the charging of the battery 15 and turn off the screen of the display 180 after displaying a notification on the display 180 indicating that an error has occurred in the pogo pin 41, 43.

The main board 19 may turn on the screen of the display 180 using the charging power of the battery 15, and display a guide for checking the fastening status of the pogo pin 41, 43 and refastening them on the turned on screen.

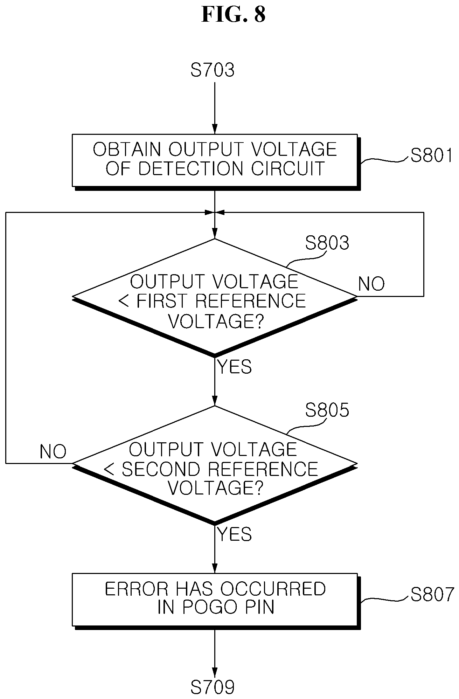

FIG. 8 may be a flowchart illustrating the process of determining whether an error has occurred in the pogo pin 41, 43 in the screen on state of the display 180 and the charge on state of the battery 15, which is the first operating state of the head 10.

In particular, FIG. 8 may be a process of determining whether an error has occurred in the pogo pin 41, 43 through two-step verification.

FIG. 8 may be an embodiment specifying steps S705 and S707 performed after step S703 of FIG. 7.

Referring to FIG. 8, the main board 19 may obtain the output voltage of the detection circuit 470 using the input voltage of the charging board 13 (S801).

The detection circuit 470 may output an output voltage relative to the input voltage through the Zener diode 510 and the LDO circuit 530.

The main board 19 may receive the output voltage from the detection circuit 470.

The main board 19 may determine whether the output voltage of the detection circuit 470 is less than or equal to a first reference voltage (S803).

The first reference voltage may be 1.8V in the screen on state of the display 180 and the charge on state of the battery 15, but this is only an example. The first reference voltage may be a voltage previously measured and set through experiment for error occurrence condition of the pogo pin 41, 43 .

The process by which the main board 19 determines whether the output voltage of the detection circuit 470 is less than or equal to the first reference voltage may be referred to as a primary verification process.

When it is determined that the output voltage of the detection circuit 470 is less than the first reference voltage, the main board 19 may determines whether the output voltage of the detection circuit 470 is less than a second reference voltage that is less than the first reference voltage (S805).

In one embodiment, the second reference voltage may be 1.74V, but this is only an example. The second reference voltage may be a voltage previously measured and set through experiment for error occurrence condition of the pogo pin 41, 43.

The process by which the main board 19 determines whether the output voltage of the detection circuit 470 is less than or equal to the second reference voltage may be referred to as a secondary verification process.

The main board 19 may perform a secondary verification process to determine whether the output voltage of the detection circuit 470 is less than the first reference voltage due to noise.

When the main board 19 determines that the output voltage of the detection circuit 470 is less than the second reference voltage, the main board 19 may determine that the error has occurred in the pogo pin 41, 43 (S807).

If it is determined that the error has occurred in the pogo pin 41, 43, the main board 19 may control the charging board 13 to turn off charging of the battery 15.

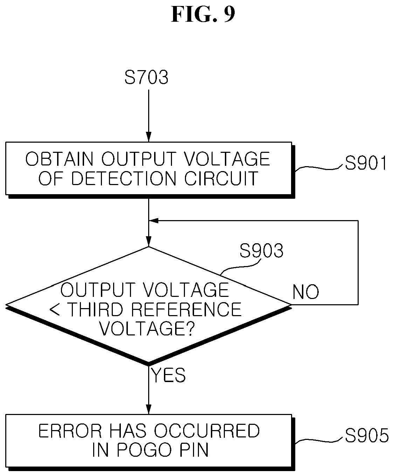

FIG. 9 may be a flowchart illustrating the process of determining whether the error occurs in the pogo pin 41, 43 in the screen on state of the display 180, which is the second operating state of the head 10, and the charge off state of the battery 15 (or the fully charged state of the battery).

FIG. 9 may be a process of determining whether the error has occurred in the pogo pin 41, 43 through the first step of verification.

FIG. 9 may be an embodiment specifying steps S705 and S707 performed after step S703 of FIG. 7 .

Referring to FIG. 9, the main board 19 may obtain the output voltage of the detection circuit 470 using the input voltage of the charging board 13 (S901).

The detection circuit 470 may output an output voltage relative to the input voltage through the Zener diode 510 and the LDO circuit 530.

The main board 19 may receive the output voltage from the detection circuit 470.

The main board 19 may determine whether the output voltage of the detection circuit 470 is less than or equal to a third reference voltage (S903).

In the screen on state of the display 180 and the charge off state of the battery 15, the third reference voltage may be 3.0V, but this is only an example. The third reference voltage may be a voltage previously measured and set through experiment for error occurrence condition of the pogo pin 41, 43 .

The process by which the main board 19 determines whether the output voltage of the detection circuit 470 is less than or equal to the third reference voltage may be referred to as a primary verification process.

When it is determined that the output voltage of the detection circuit 470 is less than the third reference voltage, the main board 19 may determine that the error has occurred in the pogo pin 41, 43 (S905).

When it is determined that the error has occurred in the pogo pin 41, 43, the main board 19 may display a notification indicating the occurrence of an error in the pogo pin 41, 43 on the display 180.

After a certain period of time, the main board 19 may turn off the screen of the display 180 (standby state) for system stability.

In the screen off state of the display 180 and the charge off state of the battery 15, the power consumption of the head 10 is less than 0.5W, so the possibility of ignition due to the pogo pin 41, 43 may be eliminated.

The main board 19 may display a guide for a damage check or a reconnection of the pogo pin 41, 43 using the power charged in the battery 15 on the display 180.

The reason for performing only primary verification when the battery 15 is in the charge off state or the full charge state is that it is not actively charging, thus significantly reducing the likelihood of battery 15 overheating.

When the main board 19 detects the error in the pogo pin 41, 43 by performing the primary verification in the screen off state of the display 180 and the full charge state of the battery 15, may record the output voltage of the detection circuit 470 in a memory (not shown).

When the charge state of the battery 15 changes from the full charge state to the charge on state, the main board 19 may perform the secondary verification by comparing the recorded output voltage with a threshold voltage less than the third reference voltage. The threshold voltage less than the third reference voltage may be 2.9V.

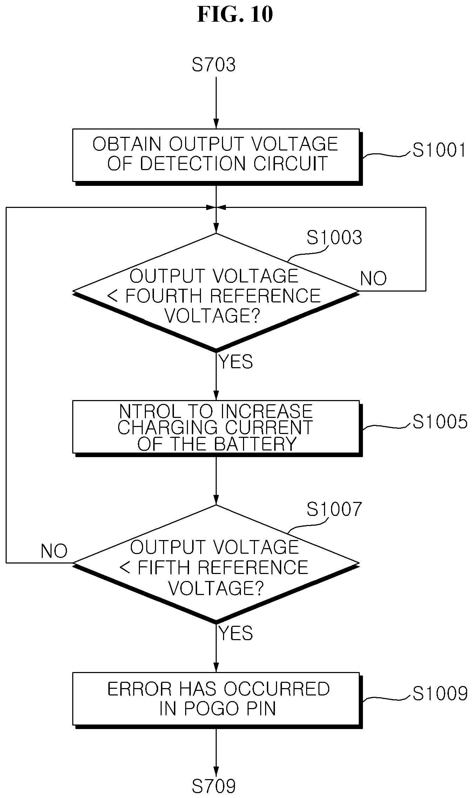

FIG. 10 may be a flowchart illustrating the process of determining whether an error has occurred in the pogo pin 41, 43 in the screen off state of the display 180 and the charge on state of the battery 15, which is the third operating state of the head 10.

In particular, FIG. 10 may be a process of determining whether the error has occurred in the pogo pin 41, 43 through two-step verification.

FIG. 10 may be an embodiment specifying steps S705 and S707 performed after step S703 of FIG. 7.

Referring to FIG. 10, the main board 19 may obtain the output voltage of the detection circuit 470 using the input voltage of the charging board 13 (S1001).

The detection circuit 470 may output an output voltage relative to the input voltage through the Zener diode 510 and the LDO circuit 530.

The main board 19 may receive the output voltage from the detection circuit 470.

The main board 19 may determine whether the output voltage of the detection circuit 470 is less than or equal to a fourth reference voltage (S1003).

In the screen off state of the display 180 and the charge on state of the battery 15, the fourth reference voltage may be 2.6V, but this is only an example. The fourth reference voltage may be a voltage previously measured and set through an experiment for error occurrence condition of the pogo pin 41, 43 .

The process by which the main board 19 determines whether the output voltage of the detection circuit 470 is less than or equal to the fourth reference voltage may be referred to as a primary verification process.

When the output voltage of the detection circuit 470 is less than the fourth reference voltage, the main board 19 may control the charging board 13 to increase a charging current of the battery 15 (S1005).

The main board 19 may increase the charging current of the battery 15 by a certain magnitude, thereby increasing the power consumed by the head 10 to 60W. This is to increase the power consumed by the head 10 in the third operation state to the same amount as the power consumed by the head 10 in the first operation state, thereby increasing the change in the output voltage of the detection circuit 470. When the change in output voltage of the detection circuit 470 increases, it may be more accurately distinguished whether the pogo pin 41, 43 is normally connected. This will be described later.

Afterwards, the main board 19 may determine whether the output voltage of the detection circuit 470 is less than a fifth reference voltage, which is less than the fourth reference voltage (S 1007).

In one embodiment, the fourth reference voltage may be 2.59V, but this is only an example. The fifth reference voltage may be a voltage previously measured and set through experiment.

The process by which the main board 19 determines whether the output voltage of the detection circuit 470 is less than or equal to the fifth reference voltage may be referred to as a secondary verification process.

The main board 19 may perform the secondary verification process to determine whether the output voltage of the detection circuit 470 is less than the fourth reference voltage due to noise.

When it is determined that the output voltage of the detection circuit 470 is less than the fifth reference voltage, the main board 19 may determine that the error has occurred in the pogo pin 41, 43 (S1009).

If it is determined that the error has occurred in the pogo pin 41, 43, the main board 19 may control the charging board 13 to turn off charging of the battery 15. Afterwards, the main board 19 may supply power to the display 180 using the charging power of the battery 15. The display 180 may display a notification indicating that the error has occurred in the pogo pin 41, 43 through power supplied from the battery 15.

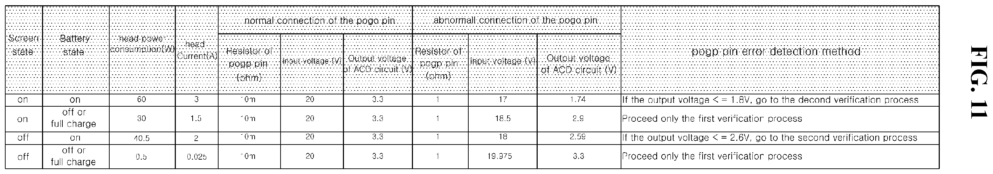

FIG. 11 is a diagram illustrating a pogo pin error verification method according to each operation state of the head according to the present disclosure.

First, the power consumption structure of the display device 1 according to an embodiment of the present disclosure will be described. However, a value of the power consumption structure is only an example.

The screen off state may be a standby state in which the power mode of the display 180 is a standby mode.

In the screen on state and the charge on state (when charging) of the battery 15, the power consumption of the head 10 may be 60W.

In the screen on state and the full charge state of the battery 15, the power consumption of the head 10 may be 30W.

In the screen off state and the charge on state of the battery 15, the power consumption of the head 10 may be 40.5W.

In the screen off state and the full charge state of the battery 15, the power consumption of the head 10 may be 0.5W.

Hereinafter, it is assumed that the adapter provided on the power board 21 outputs a direct current voltage of 20V.

First, the first operating state of the head 10, which is the screen on state of the display 180 and the charge on state of the battery 15, will be described.

In the first operating state, the power consumption of the head 10 is 60W, and the current flowing into the head 10 or the current flowing through the pogo pin 41, 43 is 3A. When the pogo pin 41, 43 is normally connected to the head connector 11, the resistance of the pogo pin 41, 43 is measured as 10m ohms, the input voltage input to the charging board 13 is 20V, and the output voltage of the detection circuit (470, ACD circuit) is 3.3V.

The input voltage input to the charging board 13 may be the input voltage of the detection circuit 470.

If the pogo pin 41, 43 is abnormally connected to the head connector 11, the resistance of the pogo pin 41, 43 is measured as a resistance of 1 ohm, and the input voltage input to the charging board 13 is 17V and the output voltage of the detection circuit (470, ACD circuit) is 1.74V.

In the first operating state, the main board 19 may determine that no error occurs in the pogo pin 41, 43 when the output voltage of the detection circuit 470 is 1.8 V or more and 3.3 V or less. This is to prevent a stability of the system from being broken by indiscriminately turning off the power of the display device 1.

If the output voltage of the detection circuit 470 is less than the first reference voltage 1. 8V, the main board 19 may perform the secondary verification to determine whether the effect is temporary due to noise.

The main board 19 may perform the secondary verification process because the output voltage of the detection circuit 470 is 1.74V, which is less than the first reference voltage 1.8V.

Next, the second operating state of the head 10, which is the screen on state of the display 180 and the charge off state or the full charge state of the battery 15, will be described.

In the second operating state, the power consumption of the head 10 is 30W, and the current flowing through the head 10 is 1.5A. When the pogo pin 41, 43 is normally connected to the head connector 11, the resistance of the pogo pin 41, 43 is measured as 10m ohms, the input voltage input to the charging board 13 is 20V, and te output voltage of the detection circuit (470, ACD circuit) is 3.3V.

If the pogo pins (41, 43) are abnormally connected to the head connector (11), the resistance of the pogo pins (41, 43) is measured as a resistance of 1 ohm, and the input voltage input to the charging board (13) is 18.5V. and the output voltage of the detection circuit (470, ACD circuit) is 2.9V.

In the second operating state, the main board 19 may determine that no error occurs in the pogo pin 41, 43 when the output voltage of the detection circuit 470 is 3.0 V or more and 3.3 V or less. This is to prevent the stability of the system from being broken by indiscriminately turning off the power of the display device 1.

If the output voltage of the detection circuit 470 is less than the third reference voltage 3.0V, the main board 19 may determine that the error has occurred in the pogo pin 41, 43.

The main board 19 does not perform the secondary verification because the output voltage of the detection circuit 470 is less than the third reference voltage (3.0V), but the charging state of the battery 15 is the charge off state or the full charge state.

Next, the third operating state of the head 10, which is the screen off state of the display 180 and the charge on state of the battery 15, will be described.

In the third operating state, the power consumption of the head 10 is 40.5W, and the current flowing through the head 10 is 2A. When the pogo pin 41, 43 is normally connected to the head connector 11, the resistance of the pogo pin 41, 43 is measured as 10m ohms, the input voltage input to the charging board 13 is 20V, and the detection circuit The output voltage of (470, ACD circuit) is 3.3V.

If the pogo pin 41, 43 is abnormally connected to the head connector 11, the resistance of the pogo pin 41, 43 is measured as a resistance of 1 ohm, and the input voltage input to the charging board 13 is 18V, the output voltage of the detection circuit (470, ACD circuit) is 2.59V.

In the third operation state, the main board 19 may determine that no error occurs in the pogo pin 41, 43 when the output voltage of the detection circuit 470 is 2.6V or more and 3.3V or less. This is to prevent the stability of the system from being broken by indiscriminately turning off the power of the display device 1.

If the output voltage of the detection circuit 470 is less than the fourth reference voltage (2.6V), the main board 19 may determine that the error has occurred in the pogo pin 41, 43.

The main board 19 may perform the secondary verification process because the output voltage of the detection circuit 470 is 2.59V, which is less than the fourth reference voltage 2.6V.

Next, the fourth operating state of the head 10, which is the screen off state of the display 180 and the charge off state of the battery 15, will be described.

In the fourth operating state, the power consumption of the head 10 is 0.5W, and the current flowing through the head 10 is 0.025A. When the pogo pin 41, 43 is normally connected to the head connector 11, the resistance of the pogo pin 41, 43 is measured as 10m ohms, the input voltage input to the charging board 13 is 20V, and the output voltage of the detection circuit (470, ACD circuit) is 3.3V.

If the pogo pins 41, 43 is abnormally connected to the head connector 11, the resistance of the pogo pin 41, 43 is measured as a resistance of 1 ohm, and the input voltage input to the charging board 13 is 19.975V and the output voltage of the detection circuit (470, ACD circuit) is 3.3V.

The main board 19 may only perform the primary verification process to determine whether the output voltage of the detection circuit 470 is more than the fifth reference voltage 3.3V.

This is because the power consumed by the head 10 is minimal, thereby lowering the risk of fire.

As such, in the embodiment of the present disclosure, one-stage or two-stage verification may be performed to determine whether the error has occurred in the pogo pin 41, 43 depending on each operating state of the head 10. In particular, through two-step verification, whether the error has occurred in the pogo pin 41, 43 may be measured more accurately.

Additionally, the main board 19 may set the reference voltage used when performing first and secondary verification differently depending on each operating state of the head 10.

In one embodiment, the main board 19 may perform the primary verification when the head 10 and the stand 20, 30, 40, 50 are connected through the pogo pin 41, 43. The main board 19 may perform the primary verification according to the operating state of the head 10 when the output voltage of the detection circuit 470 is above a certain voltage. Here, the constant voltage may be 0.7V, but this is only an example.

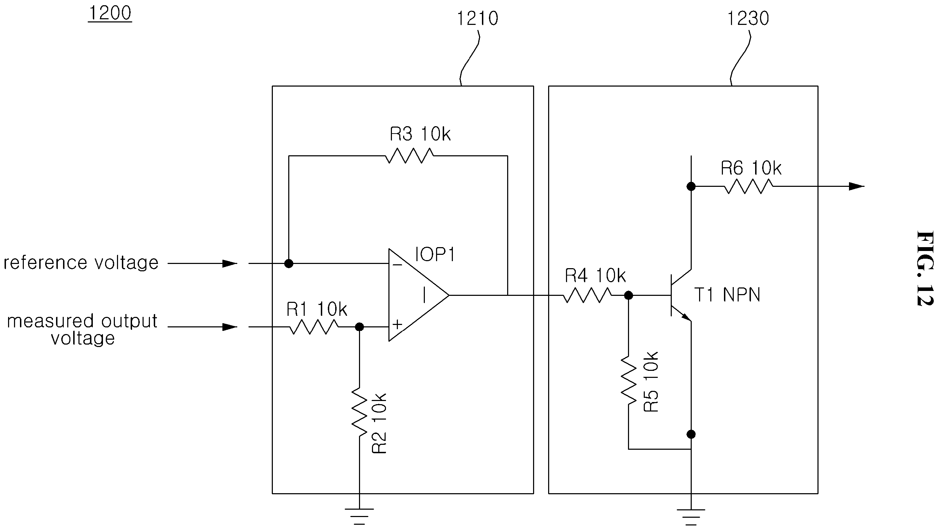

FIG. 12 is a diagram illustrating a control circuit according to an embodiment of the present disclosure.

The main board 19 may include a control circuit 1200. The control circuit 1200 may be a circuit for comparing the output voltage of the detection circuit 470 with a reference voltage and controlling the charging state of the battery 15 according to a comparison result.

The control circuit 1200 may include a comparator 1210 and a switch circuit 1230.

The comparator 1210 may include a plurality of resistors (R1, R2, R3) and an amplifier (IOP1). When the pogo pin 41, 43 is properly connected, the reference voltage output by the detection circuit 470 may be applied to the - terminal of the amplifier (IOP1), and an output voltage of the detection circuit 470, which is actually measured, may be applied to the + terminal.

The main board 19 may store a reference voltage corresponding to each of the plurality of operating states of the head 10. For this purpose, the main board 19 may include a memory (not shown). The memory (not shown) may be provided separately.

The main board 19 may store two reference voltages in memory for two-step verification for each of the first and third operating states of the head 10.

The main board 19 may store one reference voltage in memory for one-step verification for each of the second and fourth operating states of the head 10.

The comparator 1210 may amplify an error value between the reference voltage and the output voltage. The comparator 1210 may transmit the amplified error value (output value) to the switch circuit 1230.

The switch circuit 1230 may output a signal indicating whether the error has occurred in the pogo pin 41, 43 based on the amplified error value.

The switch circuit 1230 may include a plurality of resistors R4, R5, and R6 and a switch T1. The switch T1 may be an NPN type transistor.

If the amplified error value for each operating state of the head 10 is less than or equal to a preset value, the switch circuit 1230 may output a low signal indicating that the error in the pogo pin 41, 43 does not occur.

The low signal may be a control signal that turns on charging of the battery 15. The low signal may be transmitted to the charging board 13, and the charging board 13 may turn on charging of the battery 15 according to the low signal.

When the amplified error value for each operating state of the head 10 exceeds the preset value, the switch circuit 1230 may output a high signal indicating that the error in the pogo pin 41, 43 has occurred.

The high signal may be a control signal that turns off charging of the battery 15. The high signal may be transmitted to the charging board 13, and the charging board 13 may turn off charging of the battery 15 according to the high signal. The high signal may be a signal for turning off the screen of the display 180 while turning off the charging of the battery 15.

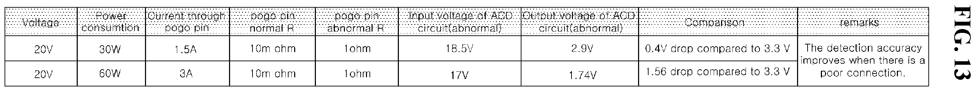

FIG. 13 is a diagram illustrating the reason for increasing the power consumed by the head when the head is in the third operation state according to an embodiment of the present disclosure.

Referring to FIG. 13, when the pogo pin 41, 43 is normally connected in the first operating state of the head 10, the output voltage of the detection circuit 470 is 3.3V and when the pogo pin 41, 43 is abnormally connected in the first operating state of the head 10, the output voltage is 1.74V. That is, the output voltage of the detection circuit 470 was reduced by 1.56V compared to 3.3V when the pogo pin 41, 43 was normally connected.

On the other hand, when the pogo pin 41, 43 is normally connected in the third operation state of the head 10, the output voltage of the detection circuit 470 is 3.3V, and when the pogo pin 41, 43 is abnormally connected in the third operation state of the head 10, the output voltage is 2.9V. That is, the output voltage of the detection circuit 470 was reduced by 0.4V compared to 3.3V when the pogo pin41, 43 was normally connected.

As a result, in the third operation state, the difference between the output voltage of the detection circuit 470 when the pogo pin 41, 43 is abnormally connected and when the pogo pin 41, 43 is normally connected is much less than in the first operation state.

Accordingly, the accuracy of detecting poor fastening of the pogo pin 41, 43 may be lowered.

In an embodiment of the present disclosure, the main board 19 may increase the power consumption in the third operating state of the head 10 by the same amount as the power consumption in the first operating state.

To this end, the main board 19 may increase the charging current of the battery 15 in the third operating state of the head 10, thereby increasing the power consumption of the head 10.

As the charging current of the battery 15 of the head 10 increases, the input voltage of the detection circuit 470 may decrease, and the output voltage of the detection circuit 470 may also decrease.

Accordingly, poor connection of the pogo pin 41, 43 may be more accurately verified in the third operating state of the head 10.

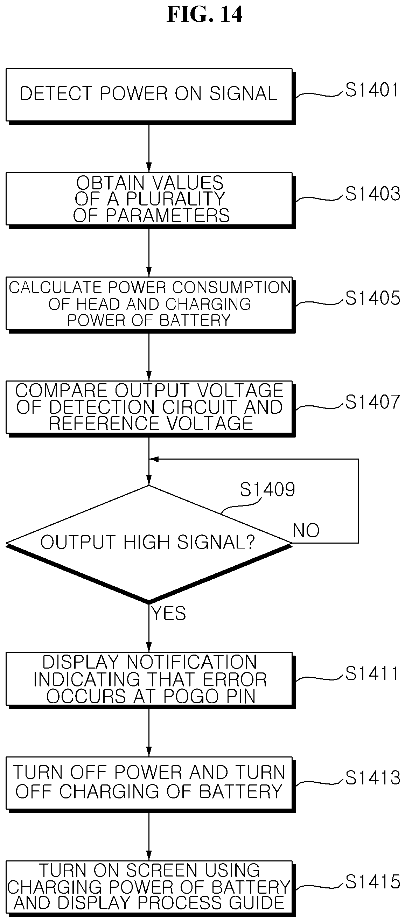

FIG. 14 is a flowchart illustrating a method of operating a display device according to another embodiment of the present disclosure.

The main board 19 of the display device 1 may detect a power on signal (S1401).

The power on signal may be a signal for turning on the head 10 or the display 180.

When the display device 1 is turned on according to a power-on signal, the main board 19 may obtain values of a plurality of parameters containing information about the display device 1 through a system on chip (SOC) (S1403).

A plurality of parameters may include a screen mode of the display device 1, a maximum driving value of the backlight, the charging state of the battery 15 (e.g., Relative State Of Charge, RSOC), the current flowing in the battery 15, and the voltage supplied to ethe battery 15.

The main board 19 may calculate the power consumption of the head 10 and the charging power of the battery 15 based on the values of the plurality of parameters (S1405).

The main board 19 may calculate the power consumption of the head 10 by multiplying the maximum power consumed by the LCD panel provided in the display 180 in the corresponding screen mode, the backlight driving value, and the backlight current coefficient.

The main board 19 may calculate the charging power of the battery by multiplying the current flowing in the battery 15 and the voltage supplied to the battery 15.

The main board 19 may compare the output voltage of the detection circuit 470 and the reference voltage using the comparator 1210 of the control circuit 1200 (S1407).

The main board 19 may obtaine the reference voltage for determining the operating state of the head 10 and whether the error has occurred in the pogo pin 41, 43 based on the power consumption of the head 10 and the charging power of the battery 15.

A value of the reference voltage may vary depending on the operating state of the head 10.

The main board 19 may determine whether the comparator 1210 outputs a high signal (S1409), and when the comparator 1210 outputs a high signal, display a notification indicating that an error occurs at the pogo pin 41, 43 on the display 180 (S1411).

Afterwards, the main board 19 may turn off the power of the display device 1 and turn off the charging of the battery 15 (S1413).

The main board 19 may turn on the screen of the display 180 using the charging power of the battery 15, and display a guide for a fastening status check of the pogo pin 41, 43 and re-fastening them on the screen (S1415).

A display device 1 according to an embodiment of the present disclosure may comprise a stand 20, 30, 40, 50 and a head 10 supported by the stand, including a display 180 and a battery 15, wherein the head is electrically connected through a pogo pin provided in a connector of the stand, wherein the head is further comprises a main board 19 configured to obtain an operating state of the head and an input voltage input to the head through the pogo pin, and determine whether an error has occurred in the pogo pin based on the operating state of the head and the input voltage.

The operating state of the head 10 may a state representing a combination between a screen state of the display and a charging state of the battery, the screen state may be either a screen on state or a screen off state, and the charging state may be either a charge on state or a charge off state.

The head 10 may further comprise a detection circuit 470 configured to output an output voltage based on the input voltage, the main board 19 may compare the output voltage and a reference voltage, and determine whether the error in the pogo pin has occurred based on a comparison result.

The reference voltage is set differently depending on the operating state of the head.

The main board may determine whether the output voltage is less than or equal to the first reference voltage when the operating state is the screen on state and the charge on state, determine whether the output voltage is less than or equal to a second reference voltage that is less than the first reference voltage, and determine that the error has occurred in the pogo pin when the output voltage is less than or equal the second reference voltage.

The main board may determine whether the output voltage is less than or equal to a third reference voltage when the operating state is the screen on state and the charge off state, and determine that the error has occurred in the pogo pin when the output voltage is less than the third reference voltage.

The charge off state indicates a full charge state of the battery, The main board 19 may store the output voltage in a memory when the output voltage is less than or equal to the third reference voltage, determine whether the stored output voltage is less than a threshold voltage less than the third reference voltage when the full charge state of the battery is changed to the charge on state, and determine that the error has occurred in the pogo pin when the stored output voltage is less than the threshold voltage less than the third reference voltage.

The main board may determine whether the output voltage is less than or equal to a fourth reference voltage when the operating state is the screen off state and the charge on state, and increase a charging current of the battery when the output voltage is less than or equal to the fourth reference voltage, and determine that the error has occurred in the pogo pin when the output voltage is less than a fifth reference voltage less than the fourth reference voltage.

The detection circuit 470 may comprise a Zener diode 510 having a Zener voltage, and a Low DropOut (LDO) circuit 530 configured to output a preset voltage when a first voltage more than a certain voltage is input and output a voltage proportional to a second voltage when the second voltage less than the certain voltage is input.

The main board 19 may comprise a comparator 1210 configured to compare the output voltage and the reference voltage, and a switch circuit 1230 configured to output a signal indicating whether the error has occurred in the pogo pin based on an output value of the comparator.

The switch circuit 1230 may output a low signal indicating that the error has not occurred in the pogo pin when the output value is less than or equal to a preset value, and output a high signal indicating that the error has occurred in the pogo pin when the output value exceeds the preset value.

The main board 19 may display a notification indicating that the error has occurred in the pogo pin on the display when it is determined that the error has occurred in the pogo pin.

The main board 19 may turn off the screen of the display and turn off charging of the battery when it is determined that the error has occurred in the pogo pin.

The main board 19 may turn on the screen of the display using a power charged in the battery while turning off the charge of the battery when it is determined that the error has occurred in the pogo pin, and display a guide for a damage or a re-connection of the pogo pin on the display.

The main board 19 may determine whether the error has occurred in the pogo pin when the stand is electrically connected to the head through the pogo pin.

The stand 20, 30, 40, 50 may comprise an adapter configured to convert an alternating current power to a direct current power, the head is further comprises a charging board 13 configured to control charging of the battery, wherein the charging board may comprise a direct current/direct current converter 410 configured to convert the direct current power delivered from the adapter into a constant voltage and supply the converted constant voltage to the main board, a charging circuit 430 configured to charge the battery using the direct current power delivered from the adapter, and the detection circuit 470.

According to an embodiment of the present disclosure, the above-described method may be implemented as processor-readable code on a program-recorded medium. Examples of media that the processor may read include ROM, RAM, CD-ROM, magnetic tape, floppy disk, and optical data storage devices.

The display device described above is not limited to the configuration and method of the above-described embodiments, and the embodiments may be configured by selectively combining all or part of each embodiment so that various modifications may be made. It may be possible.

## Claims

1. A display device (1), comprising:
a stand (20, 30, 40, 50); and
a head (10) supported by the stand (20, 30, 40, 50), including a display (180 and a battery (15), wherein the head (10) is electrically connected through a pogo pin (41, 43) provided in a connector (11) of the stand,
chracterized in that the head (10) further comprises:
a main board (19) configured to:
obtain an operating state of the head (10) and an input voltage input to the head (10) through the pogo pin (41, 43), and
determine whether an error has occurred in the pogo pin (41, 43) based on the operating state of the head (10) and the input voltage.

2. The display device (1) of claim 1, wherein the operating state of the head (10) is a state representing a combination between a screen state of the display (180) and a charging state of the battery (15),
wherein the screen state is either a screen on state or a screen off state, and the charging state is either a charge on state or a charge off state.

3. The display device (1) of claim 2, wherein the head (10) further comprises a detection circuit (470) configured to output an output voltage based on the input voltage,
wherein the main board (19) is configured to:
compare the output voltage and a reference voltage, and
determine whether the error in the pogo pin (41, 43) has occurred based on a comparison result.

4. The display device (1) of claim 3, wherein the reference voltage is set differently depending on the operating state of the head.

5. The display device (1) of claim 4, wherein the main board (19) is configured to:
determine whether the output voltage is less than or equal to the first reference voltage when the operating state is the screen on state and the charge on state,
determine whether the output voltage is less than or equal to a second reference voltage that is less than the first reference voltage, and
determine that the error has occurred in the pogo pin (41, 43) when the output voltage is less than or equal the second reference voltage.

6. The display device (1) of claim 4, wherein the main board (19) is configured to:
determine whether the output voltage is less than or equal to a third reference voltage when the operating state is the screen on state and the charge off state, and
determine that the error has occurred in the pogo pin (41, 43) when the output voltage is less than the third reference voltage.

7. The display device (1) of claim 6, wherein the charge off state indicates a full charge state of the battery,
wherein the main board (19) is configured to:
store the output voltage in a memory when the output voltage is less than or equal to the third reference voltage,
determine whether the stored output voltage is less than a threshold voltage less than the third reference voltage when the full charge state of the battery (15) is changed to the charge on state, and
determine that the error has occurred in the pogo pin (41, 43) when the stored output voltage is less than the threshold voltage less than the third reference voltage.

8. The display device (1) of claim 4, wherein the main board (19) is configured to:
determine whether the output voltage is less than or equal to a fourth reference voltage when the operating state is the screen off state and the charge on state, and
increase a charging current of the battery (15) when the output voltage is less than or equal to the fourth reference voltage, and
determine that the error has occurred in the pogo pin (41, 43) when the output voltage is less than a fifth reference voltage less than the fourth reference voltage.

9. The display device (1) of claim 3, wherein the detection circuit (470) comprises:
a Zener diode (510) having a Zener voltage, and
a Low DropOut (LDO) circuit (530) configured to output a preset voltage when a first voltage more than a certain voltage is input and output a voltage proportional to a second voltage when the second voltage less than the certain voltage is input.

10. The display device (1) of claim 3, wherein the main board (19) comprises:
a comparator (1210) configured to compare the output voltage and the reference voltage, and
a switch circuit (1230) configured to output a signal indicating whether the error has occurred in the pogo pin (41, 43) based on an output value of the comparator (1210) .

11. The display device (1) of claim 10, wherein the switch circuit (1230) is configured to:
output a low signal indicating that the error has not occurred in the pogo pin (41, 43) when the output value is less than or equal to a preset value, and
output a high signal indicating that the error has occurred in the pogo pin (41, 43) when the output value exceeds the preset value.

12. The display device (1) of claim 1, wherein the main board (19) is further configured to display a notification indicating that the error has occurred in the pogo pin (41, 43) on the display (180) when it is determined that the error has occurred in the pogo pin (41, 43).

13. The display device (1) of claim 1, wherein the main board (19) is further configured to turn off the screen of the display (180) and turn off charging of the battery (15) when it is determined that the error has occurred in the pogo pin (41, 43).

14. The display device (1) of claim 13, wherein the main board (19) is configured to:
turn on the screen of the display (180) using a power charged in the battery (15) while turning off the charge of the battery (15) when it is determined that the error has occurred in the pogo pin (41, 43), and
display a guide for a damage or a re-connection of the pogo pin (41, 43) on the display (180).

15. The display device of (1) claim 3, wherein the stand comprises an adapter configured to convert an alternating current power to a direct current power,
wherein the head (10) is further comprises a charging board (13) configured to control charging of the battery (15),
wherein the charging board (13) comprises:
a direct current/direct current converter (410) configured to convert the direct current power delivered from the adapter into a constant voltage and supply the converted constant voltage to the main board (19),
a charging circuit (430) configured to charge the battery (15) using the direct current power delivered from the adapter, and
the detection circuit (470).

## Amended claims

### Amended claims in accordance with Rule 137(2) EPC.

**1.** A display device (1), comprising:
a stand (20, 30, 40, 50); and
a head (10) supported by the stand (20, 30, 40, 50), including a display (180 and a battery (15), wherein the head (10) is electrically connected through a pogo pin (41, 43) provided in a connector (11) of the stand,
wherein the head (10) further comprises:
a main board (19) configured to:
obtain an operating state of the head (10) and an input voltage input to the head (10) through the pogo pin (41, 43),
**characterized in that** the operating state of the head (10) is a state representing a combination between a screen state of the display (180) and a charging state of the battery (15), the screen state is either a screen on state or a screen off state, and the charging state is either a charge on state or a charge off state, and
determine whether an error has occurred in the pogo pin (41, 43) based on the operating state of the head (10) and the input voltage.

**2.** The display device (1) of claim 1, wherein the head (10) further comprises a detection circuit (470) configured to output an output voltage based on the input voltage,
wherein the main board (19) is configured to:
compare the output voltage and a reference voltage, and
determine whether the error in the pogo pin (41, 43) has occurred based on a comparison result.

**2.** The display device (1) of claim 2, wherein the reference voltage is set differently depending on the operating state of the head.

**4.** The display device (1) of claim 3, wherein the main board (19) is configured to:
determine whether the output voltage is less than or equal to the first reference voltage when the operating state is the screen on state and the charge on state,
determine whether the output voltage is less than or equal to a second reference voltage that is less than the first reference voltage, and
determine that the error has occurred in the pogo pin (41, 43) when the output voltage is less than or equal the second reference voltage.

**5.** The display device (1) of claim 3, wherein the main board (19) is configured to:
determine whether the output voltage is less than or equal to a third reference voltage when the operating state is the screen on state and the charge off state, and
determine that the error has occurred in the pogo pin (41, 43) when the output voltage is less than the third reference voltage.

**6.** The display device (1) of claim 5, wherein the charge off state indicates a full charge state of the battery, wherein the main board (19) is configured to:
store the output voltage in a memory when the output voltage is less than or equal to the third reference voltage,
determine whether the stored output voltage is less than a threshold voltage less than the third reference voltage when the full charge state of the battery (15) is changed to the charge on state, and
determine that the error has occurred in the pogo pin (41, 43) when the stored output voltage is less than the threshold voltage less than the third reference voltage.

**7.** The display device (1) of claim 3, wherein the main board (19) is configured to:
determine whether the output voltage is less than or equal to a fourth reference voltage when the operating state is the screen off state and the charge on state, and
increase a charging current of the battery (15) when the output voltage is less than or equal to the fourth reference voltage, and
determine that the error has occurred in the pogo pin (41, 43) when the output voltage is less than a fifth reference voltage less than the fourth reference voltage.

**8.** The display device (1) of claim 2, wherein the detection circuit (470) comprises:
a Zener diode (510) having a Zener voltage, and
a Low DropOut (LDO) circuit (530) configured to output a preset voltage when a first voltage more than a certain voltage is input and output a voltage proportional to a second voltage when the second voltage less than the certain voltage is input.

**9.** The display device (1) of claim 2, wherein the main board (19) comprises:
a comparator (1210) configured to compare the output voltage and the reference voltage, and
a switch circuit (1230) configured to output a signal indicating whether the error has occurred in the pogo pin (41, 43) based on an output value of the comparator (1210) .

**10.** The display device (1) of claim 9, wherein the switch circuit (1230) is configured to:
output a low signal indicating that the error has not occurred in the pogo pin (41, 43) when the output value is less than or equal to a preset value, and
output a high signal indicating that the error has occurred in the pogo pin (41, 43) when the output value exceeds the preset value.

**11.** The display device (1) of claim 1, wherein the main board (19) is further configured to display a notification indicating that the error has occurred in the pogo pin (41, 43) on the display (180) when it is determined that the error has occurred in the pogo pin (41, 43).

**12.** The display device (1) of claim 1, wherein the main board (19) is further configured to turn off the screen of the display (180) and turn off charging of the battery (15) when it is determined that the error has occurred in the pogo pin (41, 43).

**13.** The display device (1) of claim 12, wherein the main board (19) is configured to:
turn on the screen of the display (180) using a power charged in the battery (15) while turning off the charge of the battery (15) when it is determined that the error has occurred in the pogo pin (41, 43), and
display a guide for a damage or a re-connection of the pogo pin (41, 43) on the display (180).

**14.** The display device of (1) claim 2, wherein the stand comprises an adapter configured to convert an alternating current power to a direct current power,
wherein the head (10) is further comprises a charging board (13) configured to control charging of the battery (15), wherein the charging board (13) comprises:
a direct current/direct current converter (410) configured to convert the direct current power delivered from the adapter into a constant voltage and supply the converted constant voltage to the main board (19),
a charging circuit (430) configured to charge the battery (15) using the direct current power delivered from the adapter, and
the detection circuit (470).
